# EUROPEAN PATENT SPECIFICATION

(11) **EP 2 051 286 B1**
(45) Date of publication and mention of the grant of the patent: **10.10.2012**
(21) Application number: 07792441.3
(22) Date of filing: 07.08.2007
(51) Int. Cl.: H01L 21/205, C23C 16/44, C30B 25/08, C30B 29/38, C30B 35/00, C30B 25/12, C30B 29/40, C23C 16/30, C23C 16/458

(54) **REACTOR AND METHOD FOR NITRIDE-BASED SEMICONDUCTOR MANUFACTURING**
REAKTOR UND VERFAHREN ZUR HERSTELLUNG VON NITRID-BASIERTEN HALBLEITER
REACTEUR ET PROCEDE POUR LA FABRICATION DE SEMI-CONDUCTEURS DU TYPE NITRURE

(30) Priority: 08.08.2006 JP 2006215694
(43) Date of publication of application: 22.04.2009
(73) Proprietor: National Institute for Materials Science, Tsukuba-shi, Ibaraki 305-0047 (JP)
(72) Inventor: SAKUMA, Yoshiki, Ibaraki 3050047 (JP)
(74) Representative: Vossius & Partner
(86) International application number: PCT/JP2007/065798
(87) International publication number: WO 2008/018613

(56) References cited:
- WO-A1-2006/058847
- JP-A- 05 041 541
- JP-A- 10 097 994
- JP-A- 2001 077 476
- JP-A- 2002 173 393
- JP-A- 2003 264 155
- US-A- 4 592 307
- US-A1- 2003 209 326
- US-A1- 2004 175 939
- TANDON A ET AL: "Highly p-type carbon-doped InGaAs grown by atmospheric pressure organometallic vapor-phase epitaxy" JOURNAL OF CRYSTAL GROWTH, ELSEVIER, AMSTERDAM, NL LNKD- DOI:10.1016/S0022-0248(98)00397-2, vol. 192, no. 1-2, 15 August 1998 (1998-08-15), pages 47-55, XP004141532 ISSN: 0022-0248

## Description

### Technical Field

The present invention relates to a tube reactor having therein a susceptor provided for disposing a substrate and a vapor phase growth apparatus using the tube reactor, and more particularly to a tube reactor, a vapor phase growth apparatus, and the like, which are used for crystal growth or a heat treatment of a nitride-based compound semiconductor made from GaN, AlN or InN, or a mix crystal thereof.

### Background Art

In recent years, attention has been focused on a thin film epitaxial growth technology for a nitride semiconductor made from GaN, AlN or InN, or a mix crystal thereof. The thin film epitaxial growth technology is aimed to be applied to light emitting devices such as light emitting diodes (LEDs) and laser diodes (LDs) which emit light in the blue to ultraviolet spectral region utilizing a quantum well structure of, for example, GaN/InGaN/GaN or AlGaN/GaN/AlGaN. The thin film epitaxial growth technology is also aimed to be applied to field effect transistors (e.g., HFET, HEMT) utilizing a high-density two-dimensional electron gas (2DEG) that is generated at hetero-interface of two materials such as AlGaN/GaN and InAlN/GaN, which are different in band gap.

At present, a metal organic chemical vapor deposition (which is called MOCVD or MOVPE: Metal-organic Vapor Phase Epitaxy) is widely used as a technology for growing an epitaxial thin film toward practical use.

In this growth technology, as group III elements (Al, Ga, In) constituting an epitaxial layer, organometallic compounds such as trimethylaluminum; TMAl, trimethyl gallium; TMGa, trimethyl indium; TMIn are mixed with a highly purified H₂ gas or N₂ gas, and at the same time, ammonia (NH₃) is fed as a source gas of nitrogen (N), which is a group V element.

In a tube reactor, a susceptor made of graphite, SiC, or the like which is heated up to a high temperature through resistance heating or high-frequency induction heating is provided. The aforementioned gas is mixed in an upper stream region of a substrate, which is disposed on the susceptor, and the gas is thermally decomposed so as to induce a chemical reaction in an upper layer portion or an upper surface of the substrate. Through this process, a desired epitaxial thin film (hereinafter referred to simply as an epifilm) is formed.

Growth conditions, in particular, an optimal growth temperature, for attaining a nitride thin film having a high crystalline quality have been searched under elaborate investigations. For example, in the case where GaN is used for the nitride thin film, the optimal temperature has been found out to be around 1050°C, and, in the case where AlN is used, the optimal temperature has been found out to be around 1200°C. Particularly in the quantum well structure playing an important role for a higher performance of an optical device that emits light in the blue spectral region, an InGaN mixed crystal is used. This InGaN mixed crystal contains 10%-level In for the purpose of confining carriers and light through a reduction of band gap. In many cases, the growth temperature of the InGaN mixed crystal is set around 800°C.

Such MOCVD technology for nitride-based semiconductors has advanced rapidly in the past ten-odd years. At present, in a GaN epifilm, a non-doped crystal in the range of 10¹⁶ to 10¹⁷ cm⁻³ (electron concentration at room temperature) has been attained. Accordingly, with an addition of a small amount of SiH₄, an Si-doped n-type crystal has been achieved. Also, with an addition of Cp₂Mg, an Mg-doped p-type crystal has been attained. In such circumstances, application of the MOCVD technology to the optical and electronic devices described above has begun. These advances are based on development of a two-step growth technology in which GaN and AlN buffer layers are deposited on a substrate at a relatively low temperature in the range of 500 to 800°C, and then, an epifilm made of GaN is formed at a high temperature.

A large quantity of residual donors would be taken into the GaN epifilm before the application of the low-temperature buffer layer technology, and the electron concentration at the room temperature would be in the range of 10¹⁸ to 10²⁰ cm⁻³ without intentional addition of dopants. This hindered the formation of a p-type epifilm achieved through a concentration control of an n-type epifilm and addition of an acceptor dopant, which are necessary for fabricating a semiconductor device.

Ga-site substituted silicon (Si) and N-site substituted oxygen (O) are pointed out as main causes of the residual donor impurities, of which oxygen, in particular, was considered to be the major cause.

It is a background why the oxygen was considered to be the major cause that the GaN crystal before the development of the low-temperature buffer layer technology had a high nitrogen (N) vacancy concentration and a large amount of oxygen (O) was taken thereinto.

However, the crystallinity of the GaN film on the buffer layer has been improved with the advent of the low-temperature buffer layer technology, followed by a drastic reduction of the point defect concentration of the N vacancies. Under such condition, it is considered that the oxygen impurities which are to be taken into the N vacancies are reduced, which results in a significant reduction of residual electron concentration.

The source of oxygen impurity atoms is considered to be moisture (H₂O) and Oxygen (O₂) contained in the ammonia gas. However, with an increase in the purity of a source gas, it has ever since been believed that the impurities in the gas exert substantially no influence on the GaN crystal. Therefore, the high-degree purification of the source gas contributes to the current advances of the MOCVD technology for nitride semiconductors.

As described above, the MOCVD technology is presumed to have improved to a considerable level. However, there are still lots of problems that should be solved. For instance, in the case of the GaN epifilm, a growth temperature and a V/III ratio of a feed gas (an NH₃/TMGa mole ratio in a gaseous phase) must optimally be selected. Otherwise, O and Si are taken in as impurities.

Especially, the intensity of yellow luminescence observed in the vicinity of 2.2 eV of a photoluminescent (PL) spectrum of the GaN epifilm, is used as index of good or bad as a material of a light emitting device. In some cases, the intensity of yellow luminescence is largely increased according to the growth temperature and the V/III ratio. Although the cause of the yellow luminescence is a controversial issue which is still unsettled, a complex between Ga vacancy and oxygen impurity at nitrogen site (V_{Ga} - O_{N}) or a complex between Ga vacancy and Si impurity at Ga site (V_{G3} - Si_{Ga}) is considered as the most widely accepted theory.

On the other hand, there is another longstanding theory suggesting that a complex between Ga vacancy and carbon impurity at nitrogen site (V_{Ga} - C_{N}) should be the cause of the yellow luminescence. However, in any case, a nonnegligible number of impurities are taken into the epifilm depending upon the selected growth conditions and the impurities form complex defects while being associated with the concentration of the nitrogen vacancies which is increased or decreased according to the growth conditions. This largely affects the film characteristics. Especially in the case of GaN epifilm, it is known that the yellow luminescence greatly affects the film characteristics if the growth temperature is set at a low temperature of, e.g., around 1000°C or a V/III ratio is set small. This implies that there is a source of generating the impurities such as Si and O somewhere in the MOCVD apparatus, and this source may incur a degradation of crystalline quality while being associated with the point defect concentration in the crystal.

The principle of the MOCVD is as described above, and it is often the case that the epitaxial growth is carried out in a reactor made of high-purity fused quartz. This is because the quartz is considered to be excellent in workability and also in thermal stability and chemical stability at normal temperature range. In addition, there is a merit that even if reactive deposits adhere to a quartz material by MOCVD processing, the quartz material can be repeatedly used by being cleaned with, e.g., an acid solution after being removed from the apparatus. However, the technique of using the quartz as a reactor material of the nitride-based MOCVD apparatus is inherited from a MOCVD apparatus based on compounds of arsenic and phosphorus such as GaAs and InP. Therefore, it is hard to admit that the quartz can always be optimally used. In particular, the thermal and chemical stabilities of the quartz reactor under the environment of the nitride-based MOCVD have the problems to be cited below.

There is a commonly known fact that high-purity fused quartz withstands ambient temperatures up to 1200°C. This temperature value is conceivably derived from the softening temperature of quartz that falls within a range of 1500 to 1600°C, wherein some margin of safety factor is involved. Nevertheless, when considering the quartz further from a microscopic point of view, it is also pointed out that part of a crystalline structure (SiO₄ tetrahedron) remaining in the glass starts volume expansion at around 1050°C.

The significant fact is that crystal growth is carried out usually at temperatures between 1050°C and 1080°C in the case of GaN and between 1100°C and 1200°C in the case of AlN, in the process of the nitride-based MOCVD currently being used. The foregoing temperatures fall within the range where microscopic structural change in these guartz glasses may occur in no small way. This structural change may cause disassociation of part of an Si - O chemical bond of the guartz glass, allowing Si and O to be liberated during a high-temperature MOCVD process. In addition, in the MOCVD, ammonia (NH₃) gas that is used a great deal as a feedstock has high reactivity. Therefore, the guartz is not only exposed under a high temperature environment but also reacts on the surface thereof with the ammonia gas, which, after all, raises the possibility of producing the causes of Si and O impurities.

Further, if aluminum atoms adhere to the surfaces of the guartz glass, Si and Al constituting the quartz may cause substitution reaction, where Al is taken into the glass while Si is liberated.

WO 2006/058847 A1 is related with a device for holding a substrate in a process chamber of a reactor housing, comprising a bearing area on which the substrate rests, and wherein the bearing area is transparent for the wavelength of an optical substrate treatment process.

"Highly p-type carbon-doped InGaAs grown by atmospheric pressure organometallic vapour-phase epitaxy", Journal of Crystal Growth 192 (1998), 47-55, teaches that negligible hole compensation can be induced in as-grown epilayers when annealing at a temperature below 500°C, whereas compensation occurs after annealing at 650°C. Further, it is concluded that atomic H does not passivate C acceptors, but that atomic H acts as a donor when it weakly binds to macroscopic defects as C-rich precipitates.

US patent 4,592,307 is related with a particular configuration of a conventional tube formed from quartz. Because of the risk of contaminations due to the presence of quartz in the proximity of a substrate, the substrate and the reactant gases are shielded by a PBN liner, coaxially positioned within the tube.

### Disclosure of the Invention

### Problems to be solved by the Invention

The present invention aims to provide a reactor that can eliminate the cause as a source of the generation of impurities taking into an epifilm of such a nitride semiconductor, and a semiconductor manufacturing method, a vapor phase growth apparatus and a vapor phase growth method using the reactor. The reactor and vapor phase growth method according to the invention are set forth in the claims.

### Means for solving the Problems

In order to achieve the above object, the following configurations are applied to the reactor, and the semiconductor manufacturing method, vapor phase growth apparatus and vapor phase growth method using the reactor:
(1) A reactor that houses a susceptor on which a substrate is disposed and is used for crystal growth or heat treatment, characterized in that at least the circumferential portion of the susceptor is formed of sapphire.
(2) The reactor cited in (1), characterized in that the sapphire has a tubular form.
(3) The reactor cited in (1), characterized in that the sapphire is formed on an interior surface of a quartz flow channel at least at the circumferential portion of the susceptor or in the portion facing the susceptor.
(4) A semiconductor manufacturing method characterized in that the reactor set forth in any one of (1) through (3) is used for crystal growth or heat treatment of a nitride-based compound semiconductor.
(5) A vapor phase growth apparatus that is used for growing an epitaxial film from vapor phase by making a reaction gas flow while heating a substrate which is disposed on a susceptor in a reactor, characterized in that the reactor is formed of sapphire at least at the circumferential portion of the susceptor.
(6) A vapor phase growth method characterized in that the vapor phase growth apparatus cited in (5) is used for nitride-based MOCVD or nitride-based HVPE which uses a reaction gas containing ammonia.

### Advantages of the Invention

The chemical composition of a sapphire is Al₂O₃ and the sapphire is actually a crystal not amorphous. Comparing the chemical bonding strength of a guartz glass (Si - O) with that of the sapphire (Al - O), the Al - O bonding is much firmer than the Si - O bonding. As can be presumed therefrom, the sapphire is more excellent in thermal and chemical stabilities than the quartz.

The sapphire can be stably used even at temperatures exceeding 1800°C. In addition, when polished, the sapphire becomes transparent like the quartz. Therefore, the interior of the reactor can be readily observed without trouble.

Since the sapphire has low reactivity with ammonia, it can be applied to at least part of the reactor which is so far considered to have high reactivity with ammonia in a high temperature atmosphere. This allows the liberations of Si and O to be drastically reduced.

The sapphire distinctly and effectually acts on the epitaxial growth of a high-purity GaN crystal and AlN crystal, or an AlGaN mixed crystal, or a mix crystal containing AlGaN and In added thereto.

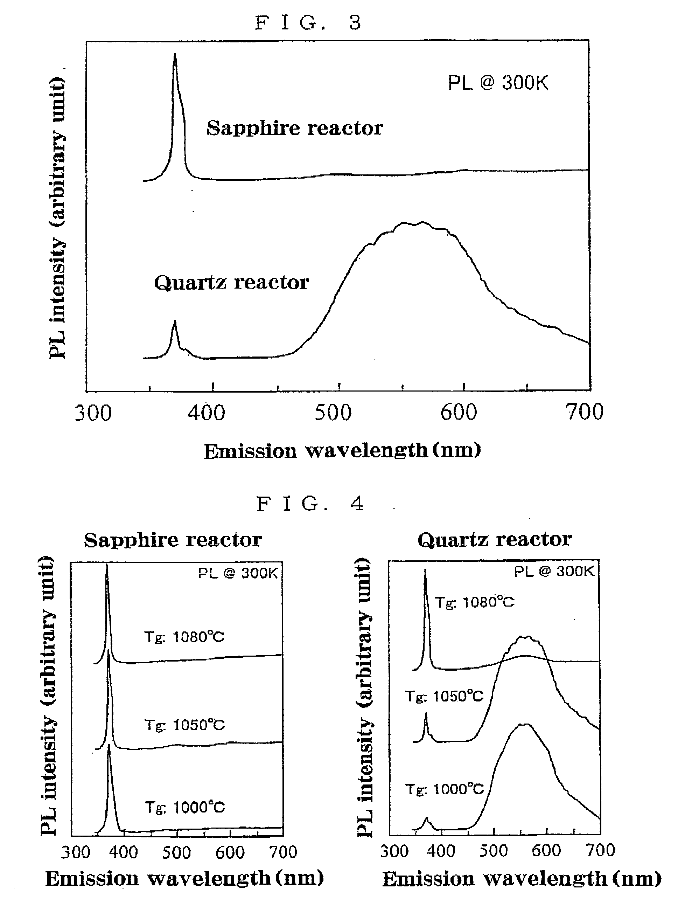

Based on such findings, the above structure can be applied, and therefore, an epifilm containing no impurities, as shown in FIG. 3, can be obtained.

### Brief Description of the Drawings

FIG. 1 is a cross-sectional front view showing a reactor according to the example 1;
FIG. 2 is a temperature program when the reactor of the example 1 is used for MOCVD of GaN;
FIG. 3 is a graph showing PL spectra in the reactor of the example 1 and in a conventional reactor, each of the PL spectra being observed following the temperature program of FIG. 2;
FIG. 4 is graphs showing PL spectra in the reactor of the example 1 and in the conventional reactor, where the growth temperature of GaN is changed stepwise at 1000°C, 1050°C and 1080°C;
FIG. 5 is a perspective view showing the upper plane of a flow channel according to the example 2, which is viewed from an upper side; and
FIG. 6 is a plan view showing the bottom portion of the flow channel of the example 2.

### Explanation of Reference Symbols

(1) Reactor
(2) (12) Susceptor
(3) Wafer
(4) Heating coil
(10) Quartz flow channel
(15) (16) Sapphire plate

### Best Mode for Carrying Out the Invention

### Example 1

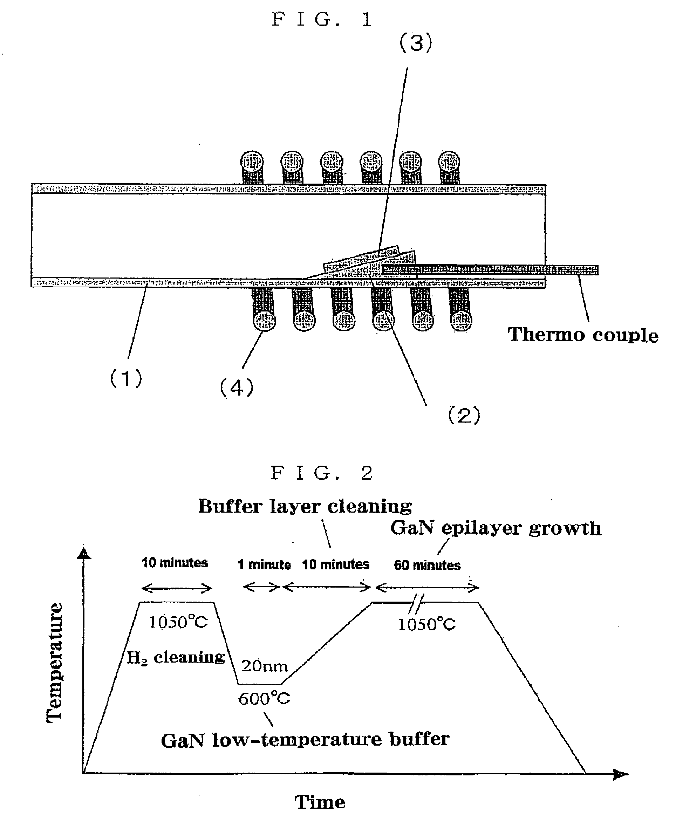

FIG. 1 is a schematic view showing a reactor of a horizontal-type MOCVD apparatus, which is most simply structured.

The reactor shown in FIG. 1 is a small-sized reactor (1) used commonly in a lab. The reactor is made up of a sapphire tube having an outer diameter of 35 mmØ.

Such a small-sized tubular shape can be obtained by shaving off an ingot of sapphire.

An SiC-coated graphite susceptor (2) and a sapphire wafer (10 mm square) (3) as an epitaxial substrate wafer of a nitride semiconductor are prepared in the tube.

A high-frequency induction heating coil (4) as a heating system surrounds the sapphire reactor (1).

An experiment was conducted using the apparatus with such a structure, where the effects obtained by using the sapphire reactor (1) was compared with those obtained by using a quartz reactor, so as to make sure the advantage of the sapphire reactor (1).

FIG. 2 is a temperature program used for GaN MOCVD.

First, the substrate (3) was cleaned with heat in H2 carrier gas at 1050°C for 10 minutes. Then, the growth temperature was lowered to 600°C, and a low-temperature buffer layer was grown up to 20 nm thick at a stabilized temperature, i.e., 600°C.

At this time, the carrier gas flow rate was set at 2000 sccm, and growth experiment was conducted under atmospheric pressure (760 Torr).

A mole ratio (V/III ratio) of the ammonia and TMGa fed in the reactor was about 3000.

Subsequently, the growth temperature was raised gradually up to 1000°C to 1080°C over a ten minute time span, and under this condition, GaN was grown to a thickness of about 1.5 µm under the condition of a V/III ratio of about 7000.

Under totally the same growth conditions, two growth samples of GaN epifilms were separately prepared under the conditions where one sample was obtained in the experiment using a reactor made of quartz and the other made of sapphire. Then, using photoluminescence (PL) impurities contained in the GaN epifilms were compared with each other.

FIG. 3 is a comparative view of PL spectra of the GaN epifilms at room temperature. The GaN epifilms were grown in the sapphire reactor and a normal quartz reactor at a growth temperature of 1050°C.

In the sample grown in the quartz reactor, yellow luminescence was observed at around 550 to 560 nm in addition to light emission from the band end of GaN at around 360 to 370 nm.

On the other hand, in the sample grown in the sapphire reactor, it was observed that the intensity of yellow luminescence of the sample was very weak and light emitted from the band end of GaN was dominant.

FIG. 4 is comparative views showing PL spectra, where the growth temperature of GaN is changed stepwise at 1000°C, 1050°C and 1080°C.

In the case of the sapphire reactor, the intensity of yellow luminescence is suppressed at any temperature from 1000°C to 1080°C, whereas in the case of the quartz reactor, although the band-end light emission is dominant at 1080°C, the intensity of yellow luminescence increases with reduction in growth temperature.

As can be understood, by using the sapphire reactor, the conditions of obtaining a high-purity GaN crystal can be broadened.

### Example 2

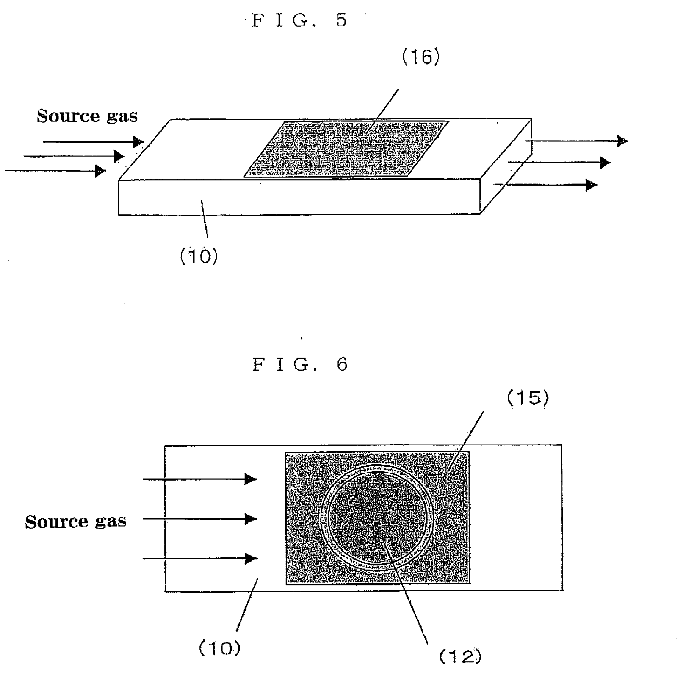

FIGS. 5 and 6 are schematic views showing a case where the present invention is applied to an intermediate-sized reactor. A tubular sapphire is available for the small-sized reactor shown in FIG. 1. However, it is commonly not easy to attain a large-sized sapphire tube, and such sapphire is costly.

The similar effects as the small-sized sapphire reactor can be expected by using a technique depicted in FIG. 5. That is, a sapphire plate (15), (16) may be configured to be fit into an interior surface of a quartz flow channel (10) at a circumferential portion of a susceptor (12) and/or at the portion facing the susceptor (12), since the susceptor (12) is a portion which is exposed in a high temperature atmosphere in the MOCVD process.

Further, although not shown, it is also beneficial to cover both sidewalls extending into the sapphire plate (15), (16).

Incidentally, the flow channel (10) is wholly housed in an SUS chamber (not shown).

### Example 3

In this embodiment, casing of a large-sized reactor will be explained.

Conventionally, a ceiling (ceiling board) made of quartz is used in a surface portion of the reactor facing a large-sized susceptor (12) also in the case of a large-sized reactor such as a planetary-type reactor that processes a plurality of wafers.

Similarly to the case of FIG. 5, in this case also, the fabrication of a high-purity crystal can be achieved if a material made of sapphire is applied to that portion of the reactor exposed in a high-temperature atmosphere.

In the above descriptions, the high-temperature susceptor (2) and the substrate wafer in each of the intermediate- and large-sized reactors were located with the wafer surface facing upward. Also in the case of a face-down reactor that is adopted in order to prevent heat conduction and adhesion of particles, the sapphire component can be located on the lower side of the reactor so as to oppose the substrate.

Further, the present invention can be applied not only to the metal organic chemical vapor deposition (MOCVD) method but also to the nitride-based HVPE method by introducing into a high-temperature reactor HCl and Ga-, In- and Al-metals, and ammonia (NH₃) gas as a feedstock. In addition thereto, the present invention may also be applied to the HVPE method where GaCl₃, InCl₃ or AlCl₃ is used as a starting material of group III, It goes without saying that the foregoing HVPE methods can also produce the same effects as those produced by the MOCVD method as long as a sapphire material is used in a necessary portion.

Furthermore, in the case where high temperature annealing treatment for a nitride crystal is necessitated, contamination of impurities such as Si and O can be avoided provided that at least part of the reactor is formed of sapphire.

### Industrial Applicability

According to the present invention, it is possible to reduce the contamination of impurities such as Si and O into an epifilm, which is concerned in the case of the quartz tube used for nitride-based MOCVD. Accordingly, a high-purity nitride-based crystal thin film can be fabricated under broader growth conditions as compared to the conventional technique, which helps provide high-performance optical and electronic devices.

Additionally, a description has been made by applying the present invention to the MOCVD method. It should be noted that similar effects can be expected also from the hydride VPE, halide VPE and other heat treatment furnace of high temperature based on the same principle. In particular, in the case of the hydride VPE, it has been pointed out for over years that HCl is introduced into a reaction system and the HCl reacts with quartz in a high temperature atmosphere so as to induce the generation of Si and O. However, by using sapphire at the portion where such reaction may occur, the reaction with the HCl is reduced. In consequence, a dramatic effect can be expected.

## Claims

1. A reactor that houses a susceptor on which a substrate is disposed and is used for crystal growth or heat treatment of a nitride-based compound semiconductor, **characterized in that**
said reactor is a small-sized reactor made up a sapphire tube, or a sapphire plate is configured to be fit into an interior surface of a quartz flow channel at a circumferential portion of said susceptor and/or at the portion facing said susceptor, or both sidewalls extending into said sapphire plate are covered by sapphire plates, or said reactor is a large-sized reactor and a ceiling board in a surface portion of the reactor facing a large-sized susceptor is made of sapphire.

2. A vapor phase growth method that is used for growing an epitaxial film from vapor phase by making a reaction gas containing ammonia flow while heating a substrate which is disposed on a susceptor in a reactor, **characterized in that**
said reactor is a small-sized reactor made up a sapphire tube, or a sapphire plate is configured to be fit into an interior surface of a quartz flow channel at a circumferential portion of said susceptor and/or at the portion facing said susceptor, or both sidewalls extending into said sapphire plate are covered by sapphire plates, or said reactor is a large-sized reactor and a ceiling board in a surface portion of the reactor facing a large-sized susceptor is made of sapphire.

3. A vapor phase growth method according to claim 2, **characterized in that**
said reactor is used for nitride-based MOCVD or nitride-based HVPE .

## Patentansprüche

1. Reaktor mit einem Suszeptor, auf dem ein Substrat angebracht ist, zum Kristallwachstum oder zur Wärmebehandlung eines Halbleiters auf der Basis einer Nitridverbindung, **dadurch gekennzeichnet, dass**
der Reaktor ein Reaktor mit kleiner Abmessung aus einem Saphirröhrchen ist oder eine Saphirplatte in eine Innenfläche eines Quarzströmungskanals an einem Umfangsbereich des Suszeptors und/oder am dem Suszeptor zugewandten Bereich eingepasst werden kann oder beide in die Saphirplatte ragenden Seitenwände mit Saphirplatten bedeckt sind oder der Reaktor ein Reaktor mit großer Abmessung ist und eine Deckplatte in einem Oberflächenbereich des Reaktors, der einem Suszeptor mit großer Abmessung zugewandt ist, aus Saphir besteht.

2. Dampfphasenaufwachsverfahren zum Aufwachsen einer Epitaxialschicht aus einer Dampfphase durch Anströmen eines ammoniakhaltigen Reaktionsgases während des Erhitzens eines auf einem Suszeptor in einem Reaktor angebrachten Substrats, **dadurch gekennzeichnet, dass**
der Reaktor ein Reaktor mit kleiner Abmessung aus einem Saphirröhrchen ist oder eine Saphirplatte in eine Innenfläche eines Quarzströmungskanals an einem Umfangsbereich des Suszeptors und/oder am dem Suszeptor zugewandten Bereich eingepasst werden kann oder beide in die Saphirplatte ragenden Seitenwände mit Saphirplatten bedeckt sind oder der Reaktor ein Reaktor mit großer Abmessung ist und eine Deckplatte in einem Oberflächenbereich des Reaktors, der einem Suszeptor mit großer Abmessung zugewandt ist, aus Saphir besteht.

3. Dampfphasenaufwachsverfahren nach Anspruch 2, **dadurch gekennzeichnet, dass** der Reaktor für MOCVD auf Nitridbasis oder HVPE auf Nitridbasis verwendet wird.

## Revendications

1. Réacteur contenant un suscepteur sur lequel un substrat est disposé et qui est utilisé pour la croissance cristalline ou un traitement thermique d'un semi-conducteur composite à base de nitrure, **caractérisé en ce que**
ledit réacteur est un réacteur de petite taille composé d'un tube en saphir, ou bien une plaque en saphir est prévue pour être mise en place dans une surface intérieure d'un canal d'écoulement en quartz sur une partie circonférentielle du suscepteur et/ou sur la partie opposée au suscepteur, ou bien les deux parois latérales s'étendant dans la plaque en saphir sont recouvertes par des plaques en saphir, ou bien le réacteur est un réacteur de grande taille et un panneau supérieur dans une partie de surface du réacteur opposée à un suscepteur de grande taille est en saphir.

2. Procédé de croissance en phase vapeur utilisé pour la croissance d'un film épitaxique à partir de la phase vapeur par obtention d'un flux de gaz de réaction contenant de l'ammoniac en chauffant un substrat disposé sur un suscepteur dans un réacteur, **caractérisé en ce que**
ledit réacteur est un réacteur de petite taille composé d'un tube en saphir, ou bien une plaque en saphir est prévue pour être mise en place dans une surface intérieure d'un canal d'écoulement en quartz sur une partie circonférentielle du suscepteur et/ou sur la partie opposée au suscepteur, ou bien les deux parois latérales s'étendant dans la plaque en saphir sont recouvertes par des plaques en saphir, ou bien le réacteur est un réacteur de grande taille et un panneau supérieur dans une partie de surface du réacteur opposée à un suscepteur de grande taille est en saphir.

3. Procédé de croissance en phase vapeur selon la revendication 2, **caractérisé en ce que**
le réacteur est utilisé pour un dépôt MOCVD à base de nitrure ou une épitaxie HVPE à base de nitrure.
